# EUROPEAN PATENT APPLICATION

(11) **EP 3 438 750 A1**
(43) Date of publication of application: **06.02.2019**
(21) Application number: 17184435.0
(22) Date of filing: 02.08.2017
(51) Int. Cl.: G03F 7/20, B24B 37/005, G01N 21/47, G01N 21/84, H01L 21/67

(54) **A DEVICE MANUFACTURING METHOD AND A COMPUTER PROGRAM PRODUCT**

(71) Applicant: ASML Netherlands B.V., 5500 AH Veldhoven (NL)
(72) Inventor: CALADO, Victor, Emanuel, 5500 AH Veldhoven (NL); VAN HAREN, Richard, Johannes, Franciscus, 5500 AH Veldhoven (NL); DEPRE, Jerome, Yann, Remi, 5500 AH Veldhoven (NL); MASSACRIER, Clément, André, Auguste, 5500 AH Veldhoven (NL)
(74) Representative: Peters, John Antoine

(57) **Abstract**

A device manufacturing method comprising: forming a layer on a substrate by a layer-forming process; determining a value of a metric at a plurality of positions across the substrate, wherein variation of the values across the substrate is indicative of variation of layer thickness across the substrate; controlling the layer-forming parameter based on the values so as to reduce variation of layer thickness in a subsequent layer-forming process on a different substrate; and repeating the layer-forming process on a different substrate according to the controlled layer-forming parameter.

## Description

### BACKGROUND

### Field of the Invention

The present invention relates to a device manufacturing method, in particular comprising steps to control a layer-forming parameter of a layer-forming process. The present invention further relates to computer program products for implementing parts of such a method.

### Background Art

A lithographic apparatus is a machine that applies a desired pattern onto a substrate, usually onto a target portion of the substrate. A lithographic apparatus is used, for example, in the manufacture of integrated circuits (ICs). In that instance, a patterning device, which is alternatively referred to as a mask or a reticle, may be used to generate a circuit pattern to be formed on an individual layer of the IC. This pattern is transferred onto a target portion (e.g., comprising part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction.

In the manufacture of devices such as ICs, layers are applied to a substrate. It is desirable for the layers to have a uniform thickness across the substrate. However, layers may not be uniform due to imperfections in the methods of forming the layers.

### SUMMARY OF THE INVENTION

The present invention has the aim of reducing variation in layer thickness across a substrate.

According to an aspect of the invention, there is provided a method for controlling a layer-forming parameter of a layer-forming process, the method comprising: measuring an asymmetry between two diffractive orders associated with a marker at a plurality of positions across a substrate, wherein the marker comprises a bottom grating and a top grating, wherein a distance between the bottom grating and the top grating corresponds to a thickness of a layer; determining a value of a metric at the plurality of positions across the substrate, the metric being calculated from the measured asymmetry and an offset associated with the marker, wherein variation of the values across the substrate is indicative of variation of layer thickness across the substrate; and controlling the layer-forming parameter based on the values so as to reduce variation of layer thickness in a subsequent layer-forming process on a different substrate.

According to another aspect of the invention, there is provided a computer program product comprising machine-readable instructions for causing one or more processors to control a layer-forming parameter of a layer-forming process by: measuring an asymmetry between two diffractive orders associated with a marker at a plurality of positions across a substrate, wherein the marker comprises a bottom grating and a top grating, wherein a distance between the bottom grating and the top grating corresponds to a thickness of a layer; determining a value of a metric at the plurality of positions across the substrate, the metric being calculated from the measured asymmetry and an offset associated with the marker, wherein variation of the values across the substrate is indicative of variation of layer thickness across the substrate; and controlling the layer-forming parameter based on the values so as to reduce variation of layer thickness in a subsequent layer-forming process on a different substrate.

### BRIEF DESCRIPTION OF THE DRAWINGS

Embodiments of the invention will now be described, by way of example only, with reference to the accompanying schematic drawings in which:
Figure 1 depicts a lithographic apparatus configured to operate according to an embodiment of the invention;
Figure 2 depicts schematically the use of the lithographic apparatus of Figure 1 together with other apparatuses forming a production facility for semiconductor devices;
Figure 3 illustrates schematically a marker associated with a layer on a substrate;
Figure 4 is a plot showing how overlay sensitivity varies across a substrate
Figure 5 depicts, in plan view, the pressure rings of a CMP tool;
Figure 6 is a graph showing the relationship between radial position on a substrate and overlay sensitivity before the present invention has been applied; and
Figure 7 is a simulated graph showing the relationship between radial position on a substrate and overlay sensitivity after the present invention has been applied.

### DETAILED DESCRIPTION OF EXEMPLARY EMBODIMENTS

Before describing embodiments of the invention in detail, it is instructive to present an example environment in which embodiments of the present invention may be implemented.

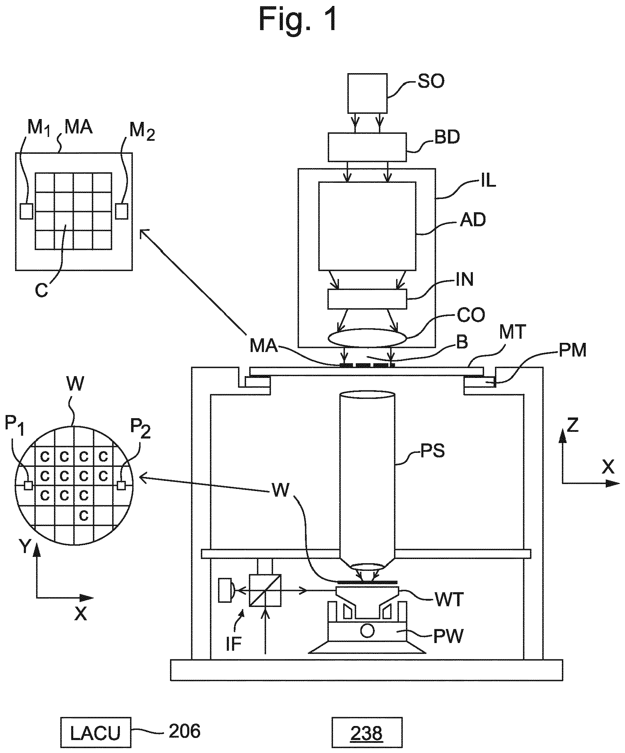

Figure 1 schematically depicts a lithographic apparatus LA. The apparatus comprises:
- an illumination system (illuminator) IL configured to condition a radiation beam B (e.g. UV radiation or EUV radiation).
- a support structure (e.g. a mask table) MT constructed to support a patterning device (e.g. a mask or reticle) MA and connected to a first positioner PM configured to accurately position the patterning device in accordance with certain parameters;
- a substrate table (e.g. a wafer table) WTa or WTb constructed to hold a substrate (e.g. a resist coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that may be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device (or a number of devices) being created in the target portion, such as an integrated circuit. The patterning device may be transmissive or reflective. Examples of patterning devices include masks, programmable mirror arrays, and programmable LCD panels.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator may be adjusted. In addition, the illuminator IL may comprise various other components, such as an integrator IN and a condenser CO. The illuminator may be used to condition the radiation beam, to have a desired uniformity and intensity distribution in its cross section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WTa/WTb is moved accurately, e.g. so as to position different target portions C in the path of the radiation beam B. Similarly, the first positioner PM and another position sensor (which is not explicitly depicted in Figure 1) is used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WTa/WTb may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (fields), and/or between device areas (dies) within target portions. These are known as scribe-lane alignment marks, because individual product dies will eventually be cut from one another by scribing along these lines. Similarly, in situations in which more than one die is provided on the mask MA, the mask alignment marks may be located between the dies.

The depicted apparatus could be used in at least one of the following modes:
1. In step mode, the mask table MT and the substrate table WTa/WTb are kept essentially stationary, while an entire pattern imparted to the radiation beam is projected onto a target portion C at one time (i.e. a single static exposure). The substrate table WTa/WTb is then shifted in the X and/or Y direction so that a different target portion C may be exposed. In step mode, the maximum size of the exposure field limits the size of the target portion C imaged in a single static exposure.
2. In scan mode, the mask table MT and the substrate table WTa/WTb are scanned synchronously while a pattern imparted to the radiation beam is projected onto a target portion C (i.e. a single dynamic exposure). The velocity and direction of the substrate table WTa/WTb relative to the mask table MT may be determined by the
   (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning device, and the substrate table WTa/WTb is moved or scanned while a pattern imparted to the radiation beam is projected onto a target portion C. In this mode, generally a pulsed radiation source is employed and the programmable patterning device is updated as required after each movement of the substrate table WTa/WTb or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

Lithographic apparatus LA in this example is of a so-called dual stage type which has two substrate tables WTa and WTb and two stations - an exposure station and a measurement station- between which the substrate tables may be exchanged. While one substrate on one substrate table is being exposed at the exposure station EXP, another substrate is loaded onto the other substrate table at the measurement station MEA so that various preparatory steps may be carried out. The preparatory steps may include mapping the surface height of the substrate using a height sensor LS and measuring the position of alignment marks on the substrate using an alignment sensor AS. The measurement is time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations.

The apparatus further includes a lithographic apparatus control unit LACU 206 which controls all the movements and measurements of the various actuators and sensors described. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus. For example, one processing subsystem may be dedicated to servo control of the substrate positioner PW. Separate units may handle coarse and fine actuators, or different axes. Another unit might be dedicated to the readout of the position sensor IF. Overall control of the apparatus may be controlled by a central processing unit, communicating with these sub-systems processing units, with operators and with other apparatuses involved in the lithographic manufacturing process.

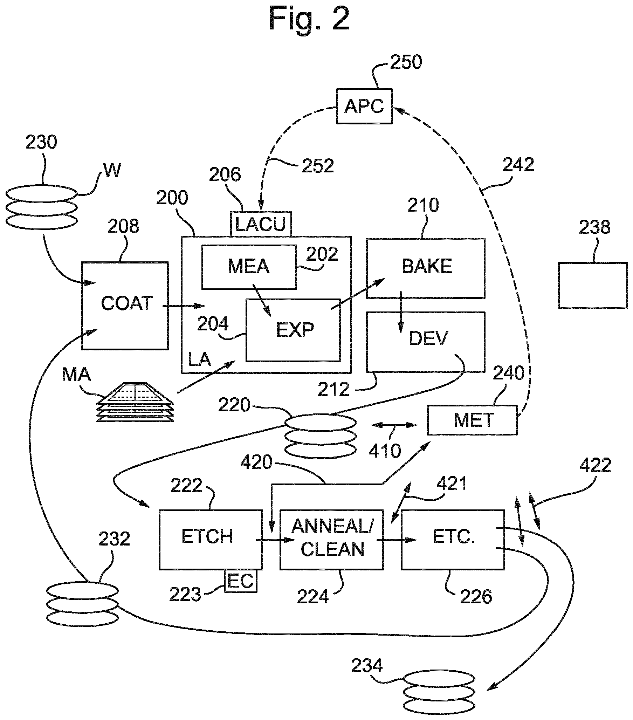

Figure 2 at 200 shows the lithographic apparatus LA in the context of an industrial production facility for semiconductor products. Within the lithographic apparatus (or "litho tool" 200 for short), the measurement station MEA is shown at 202 and the exposure station EXP is shown at 204. The control unit LACU is shown at 206. Within the production facility, apparatus 200 forms part of a "litho cell" or "litho cluster" that contains also a coating apparatus 208 for applying photosensitive resist and other coatings to substrate W for patterning by the apparatus 200. At the output side of apparatus 200, a baking apparatus 210 and developing apparatus 212 are provided for developing the exposed pattern into a physical resist pattern.

Once the pattern has been applied and developed, patterned substrates 220 are transferred to other processing apparatuses such as are illustrated at 222, 224, 226. A wide range of processing steps is implemented by various apparatuses in a typical manufacturing facility. Apparatus 222 in this embodiment is an etching station, and apparatus 224 performs a post-etch cleaning and/or annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products (substrates 234) to be sent for dicing and packaging.

Each layer of the product structure requires a different set of process steps, and the apparatuses 226 used at each layer may be completely different in type. Moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

The whole facility may be operated under control of a supervisory control system 238, which receives metrology data, design data, process recipes and the like. Supervisory control system 238 issues commands to each of the apparatuses to implement the manufacturing process on one or more batches of substrates.

Also shown in Figure 2 is a metrology apparatus 240 which is provided for making measurements of parameters of the products at desired stages in the manufacturing process. A common example of a metrology apparatus 240 in a modern lithographic production facility is a scatterometer, for example an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. As is also well known, the metrology results 242 from the apparatus 240 may be used in an advanced process control (APC) system 250 to generate signals 252 to maintain accurate performance of the patterning operations in the litho cluster, by control unit LACU 206 making small adjustments over time, thereby minimizing the risk of products being made out-of-specification, and requiring re-work. Metrology apparatus 240 and/or other metrology apparatuses (not shown) may be applied to measure properties of the processed substrates 232, 234, and incoming substrates 230.

The advanced process control (APC) system 250 may for example be configured to calibrate individual lithographic apparatuses and to allow different apparatuses to be used more interchangeably. Improvements to the apparatuses' focus and overlay (layer-to-layer alignment) uniformity have recently been achieved by the implementation of a stability module, leading to an optimized process window for a given feature size and chip application, enabling the continuation the creation of smaller, more advanced chips. The stability module in one embodiment automatically resets the system to a pre-defined baseline at regular intervals, for example each day. More detail of lithography and metrology methods incorporating the stability module can be found in US2012008127A1. The known example APC system implements three main process control loops. The first loop provides the local control of the lithography apparatus using the stability module and monitor wafers. The second APC loop is for local scanner control on-product (determining focus, dose, and overlay on product wafers). An etch controller 223 is provided for inputting at least one etch parameter into etching station 222.

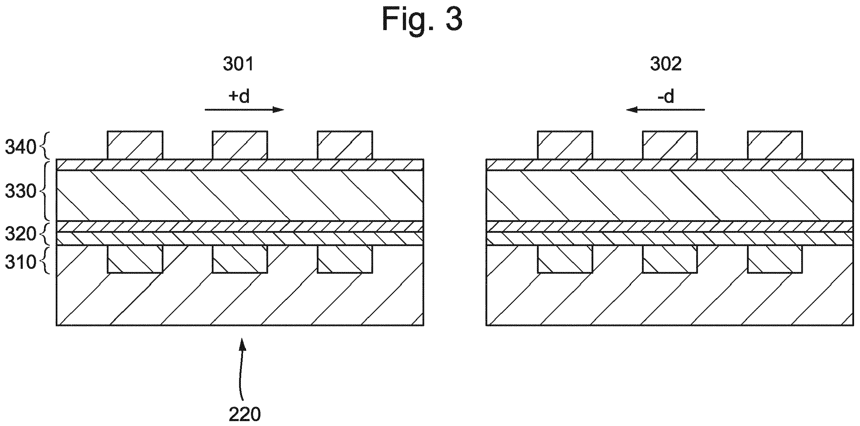

Figure 3 illustrates a marker 220 associated with a layer of a substrate W. As illustrated in Figure 3, a substrate typically includes a lower layer 310 with a pattern embedded in it. On top of the lower layer 310 one or more device layers 320 are applied. One or more further layers 330 may be applied, before a photoresist layer 340 is applied on which a pattern is irradiated by the apparatus 200 and developed into a physical resist pattern by the developing apparatus 212.

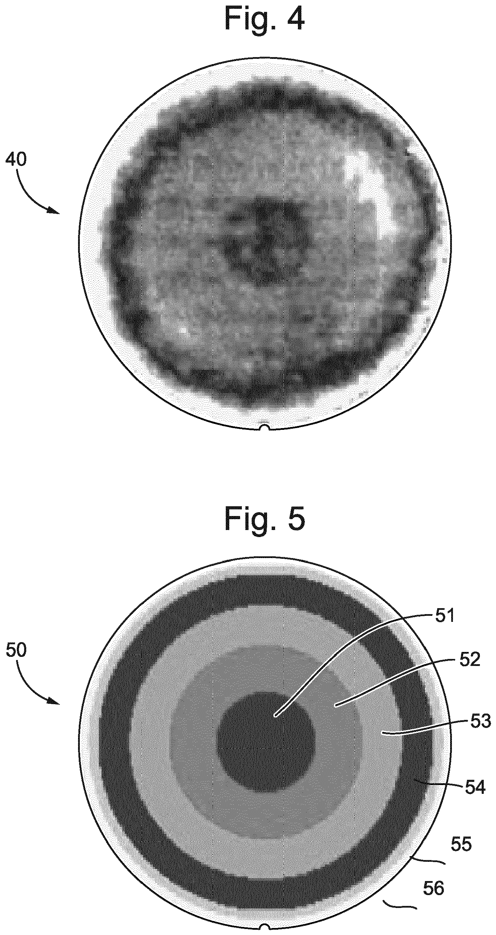

As mentioned above, the apparatus 226 may, in practice, represent a series of different processing steps performed in one or more apparatuses. In an embodiment, the apparatus 226 comprises a CMP tool 50 (depicted in plan view in Figure 5). The CMP tool 50 is configured to perform a chemical-mechanical polishing process on a substrate W. The chemical-mechanical polishing may be part of a layer-forming process.

In an embodiment the apparatus 226 comprises a layer deposition tool. The layer deposition tool is configured to deposit material in a layer-forming process. The CMP tool 50 and/or the layer deposition tool can be controlled by controlling one or more parameters. The parameters affect how a layer is formed on the substrate W.

The invention will be described below primarily with reference to a CMP process. However, it will be readily understood that invention can also be applied in the context of a different tool that affects how a layer is formed, such as a layer deposition tool.

A CMP process can be used to obtain flat and smooth surfaces for layers formed on the substrate W. A CMP process is an example of a layer-forming process. In an embodiment the CMP process comprises clamping a substrate W onto a spinning chuck. The substrate W can then be pressed to a rotating platen. In an embodiment a polishing slurry is used to help in the polishing process. The thickness of the material that forms the layer is reduced by the chemical effect of the polishing slurry and the physical forces as the substrate W is pressed to the rotating platen.

It is desirable to maintain thickness uniformity of each layer across the substrate W. In an embodiment the CMP tool 50 comprises a set of pressure rings 51-56. Each pressure ring 51-56 exerts a down pressure force on the substrate W. Each pressure ring 51-56 can be adjusted individually to control the down pressure force exerted on the substrate W by the individual pressure ring 51-56. By controlling the pressure rings 51-56 individually, the thickness uniformity of the layer can be controlled across the substrate W.

However, the thickness of a layer formed on the substrate W can vary across the substrate W. This is because the layer-forming process such as the CMP process may be non-optimal. The present invention has the aim of reducing how much the thickness of a layer varies across the substrate W.

A device manufacturing method according to the present invention comprises forming a layer 320, 330 on a substrate W by a layer-forming process. Forming such a layer has been described above in relation to Figure 2. In an embodiment the layer-forming process comprises a CMP process performed by a CMP tool 50. In an embodiment the layer-forming process comprises a layer deposition process performed by a layer deposition tool. In an embodiment, the layer 320, 330 comprises one or more device layers 320 and/or one or more further layer 330.

In an embodiment the device manufacturing method comprises determining a value of a metric at a plurality of positions across the substrate W. The metric is selected such that variation of the values across the substrate W is indicative of variation of layer thickness across the substrate W. Hence, by determining the values of the metric, it is possible to determine how the layer thickness varies across the substrate W.

The layer-forming process is performed according to a layer-forming parameter of the layer-forming process. The layer-forming parameter corresponds to one or more settings for a tool that performs the layer-forming process. For example, the layer-forming parameter may correspond to one or more settings of a CMP tool 50 and/or a layer deposition tool. In the context of a CMP tool 50, the layer-forming parameter may correspond to a downforce pressure pattern for pressure rings 51-56 of the CMP tool 50. The downforce pressure pattern is information that sets the relative downforce pressure applied to the substrate W by each of the pressure rings 51-56 of the CMP tool 50. Hence, by controlling the downforce pressure pattern, the layer thickness across the substrate W can be controlled.

Alternatively, in the context of a layer deposition tool, the layer-forming parameter may be a layer deposition pattern. The layer deposition pattern is information indicating how much material should be deposited in different locations across the substrate W in order to form a layer 320, 330. Hence, by controlling the layer deposition pattern, it is possible to control the thickness of a layer 320, 330 across the substrate W.

In an embodiment the device manufacturing method comprises controlling the layer-forming parameter based on the determined values of the metric. In an embodiment, the layer-forming parameter is controlled so as to reduce variation of layer thickness in a subsequent layer-forming process on a different substrate W. In an embodiment, the method comprises feeding data (i.e. the values of the metric) to control the layer-forming parameter on the CMP tool 50 in order to optimise the layer thickness uniformity.

In an embodiment, the device manufacturing method comprises repeating the layer-forming process on a different substrate W according to the controlled layer-forming parameter. Hence, the information gathered from one substrate W is used to improve the layer thickness uniformity for a different (subsequent) substrate W. The layer-forming process performed on the different substrate W is essentially the same. This means that the aim is to form the same layer 320, 330 on each of the substrates W. Data gathered from each substrate W can be used to reduce non-uniformity in the layer thickness of the layer formed on subsequent substrates W.

In an embodiment, determining the value of the metric comprises measuring a marker 220 in or about the layer 320, 330. For example, the marker 220 may be a structure.

Figure 3 schematically depicts a marker 220 for a layer. As depicted in Figure 3, in an embodiment the marker 220 comprises two grating sets 301, 302. Each grating set 301, 302 comprises a bottom grating and a top grating. In the marker 220 shown in Figure 3, the bottom grating is formed in the lower layer 310. The top grating is formed in the photoresist layer 340. The distance between the bottom grating and the top grating corresponds to the layer thickness. In the example shown in Figure 3, the layer thickness is the thickness of the device layers 320 combined with the further layers 330. The layer thickness may be the thickness of a single layer or multiple layers.

In an embodiment, at each position the value of the metric is determined by measuring an asymmetry between two diffractive orders associated with the marker 220 at the position. In an embodiment, the measurement is performed by the metrology apparatus 240. In an embodiment, the metrology apparatus 240 is a scatterometer. The asymmetry is the difference between the detected intensity of radiation reflected from the marker 200 for incident radiation of two diffractive orders (+1/-1). The metric is a ratio between the measured asymmetry and an offset associated with the marker. The offset may be a known offset between the top grating and the bottom grating. As explained above, the marker 220 comprises two grating sets 301, 302. Each grating set 301, 302 has a known offset (also called a bias offset) between the top grating and the bottom grating. The known offset is predetermined and is built into the marker 220 when the marker 220 is formed. In one of the grating sets 301, the top grating has a known offset of +d relative to the bottom grating. In the other grating set 302, the top grating has the opposite known offset of -d relative to the bottom grating.

A key performance parameter of the lithographic process is the overlay error. This error, often referred to simply as "overlay", is the error in placing product features in the correct position relative to features formed in previous layers. A metrology tool can be used to determine overlay values associated with a semiconductor device manufactured by the device manufacturing method. The asymmetry A scales (to first order) linearly with overlay by the overlay sensitivity K. The overlay can be derived from the measured asymmetry by the formula A=K.OV, where A represents the measured asymmetry, K represents the overlay sensitivity and OV represents the overlay. In the same way, if an offset associated with the marker 220 is known (e.g. because the offset was intentionally formed in the marker 220), the overlay sensitivity can be derived from the ratio between the measured asymmetry and the known offset (K=A/OS, where OS is the known offset). For the first grating set 301, the asymmetry A⁺=K.(OV+d). For the second grating 302, the asymmetry A⁻=K.(OV+d). From this the overlay sensitivity is found by K=(A⁺-A⁻)/2d. The overlay sensitivity K is independent of overlay OV. However, the overlay sensitivity is dependent on the wavelength of the illumination radiation, the polarisation of the illumination radiation, the polarisation of the analyser detecting the reflected radiation and the thickness of the layer between the top and bottom gratings.

Ideally, the overlay sensitivity is constant across the substrate W. However, in reality the overlay sensitivity can vary across the substrate W. This means that the relationship between the measured asymmetry and the overlay can vary across the substrate W. In particular, layer thickness variations across the substrate W can result in variations in the overlay sensitivity across the substrate W.

Figure 4 schematically depicts in plan view how the overlay sensitivity varies across a substrate W. As shown in Figure 4, there can be strong variations of the overlay sensitivity across the substrate W.

Figure 5 schematically depicts in plan view pressure rings 51-56 of a CMP tool 50. Figure 5 is a plot of the physical locations of the pressure rings 51-56 of the CMP tool 50 that was used for forming the layer analysed in Figure 4. From a comparison between Figure 4 and Figure 5, there is correlation between variations in the overlay sensitivity and the separation of the pressure rings 51-56.

In an embodiment, the measured overlay sensitivity data is fed from a metrology tool to control a layer-forming parameter on the CMP tool 50 (or another layer-forming tool) in order to increase the layer thickness uniformity.

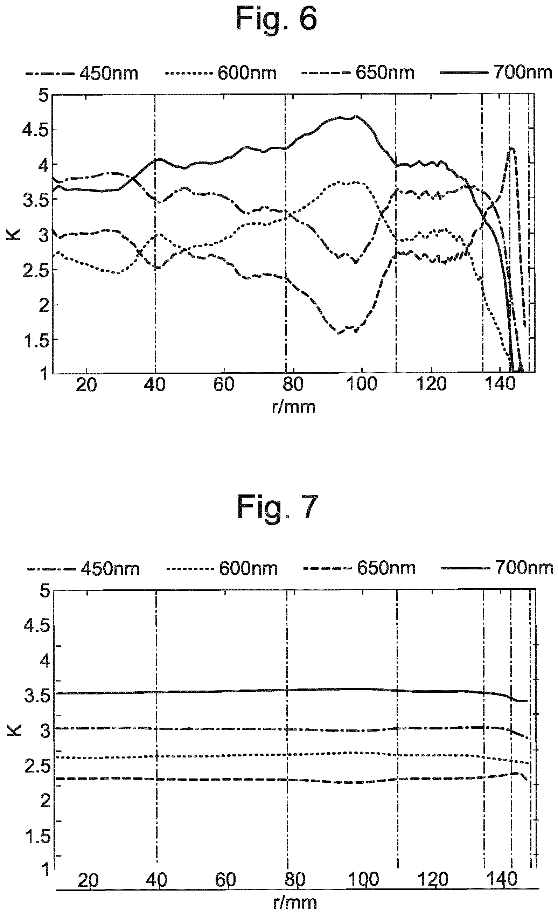

Figure 6 is a graph showing the relationship between radial position r on a substrate W and the overlay sensitivity K. Figure 6 includes vertical dot-chain lines. These lines demarcate the radius ranges for the pressure rings 51-56 of the CMP tool 50.

As mentioned above, the overlay sensitivity depends on the layer thickness. Other factors that affect the overlay sensitivity are the wavelength of radiation used, the pitch of the gratings of the marker 220 and the material of the layer. Figure 6 shows measurements taken using four different wavelengths of radiation. For each wavelength, it can be seen that there is a correlation between the overlay sensitivity and the pressure rings 51-56. This indicates the dependency of the overlay sensitivity on the thickness of the layer.

According to the present invention, the variations in the overlay sensitivity can be reduced by adjusting the downforce pressure of each of the pressure rings 51-56 individually. The relationship between the downforce pressure and the values of the overlay sensitivity can be determined by experiment.

Figure 7 schematically depicts the relationship between the radial position r on the substrate W and the overlay sensitivity K after the variations in the overlay sensitivity have been reduced by adjusting the downforce pressure of each of the pressure rings 51-56 individually. The overlay sensitivity has been calibrated so that the overlay sensitivity is more consistent across the substrate W. As a result, an embodiment of the invention is expected to improve the layer thickness uniformity in subsequent layer-forming processes performed on different substrates W.

After the initial calibration step, it is possible to monitor the overlay sensitivity from actual overlay measurements performed on subsequent substrates W. This is because of the known relationship between measured asymmetry, overlay sensitivity and overlay mentioned above.

In an embodiment, the method comprises monitoring the metric for a series of substrates W undergoing the layer-forming process and feeding back results of the monitoring for controlling the layer-forming parameter. This can then be used to maintain stability of the layer thickness uniformity. This can be done by continuously controlling the layer-forming parameter of the CMP tool 50 (or other layer-forming tool).

In an embodiment at each position the monitoring comprises measuring an asymmetry between two diffractive orders associated with a marker 220 at the position and measuring overlay associated with the marker 220. The metric is the ratio between the measured asymmetry and the measured overlay associated with the marker 220. In this way, the overlay sensitivity can be continuously monitored by taking actual overlay measurements and asymmetry measurements.

It is normal for such overlay measurements to be made. Hence, the present invention makes use of measurements that are made for other purposes in the overall lithographic process.

### Conclusion

The different steps described above may be implemented by respective software modules running on one or more processors within the patterning system. These processors may be part of the existing lithographic apparatus control unit, or additional processors added for the purpose. On the other hand, the functions of the steps may be combined in a single module or program, if desired, or they may be subdivided or combined in different sub-steps or sub-modules.

An embodiment of the invention may be implemented using a computer program containing one or more sequences of machine-readable instructions describing methods of recognizing characteristics in position data obtained by alignment sensors, and applying corrections as described above. This computer program may be executed for example within the control unit LACU 206 of Figure 2, or some other controller. There may also be provided a data storage medium (e.g., semiconductor memory, magnetic or optical disk) having such a computer program stored therein.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The breadth and scope of the present invention should not be limited by any of the above-described exemplary embodiments, but should be defined only in accordance with the following claims and their equivalents.

## Claims

1. A method for controlling a layer-forming parameter of a layer-forming process, the method comprising:
measuring an asymmetry between two diffractive orders associated with a marker at a plurality of positions across a substrate, wherein the marker comprises a bottom grating and a top grating, wherein a distance between the bottom grating and the top grating corresponds to a thickness of a layer;
determining a value of a metric at the plurality of positions across the substrate, the metric being calculated from the measured asymmetry and an offset associated with the marker, wherein variation of the values across the substrate is indicative of variation of layer thickness across the substrate; and
controlling the layer-forming parameter based on the values so as to reduce variation of layer thickness in a subsequent layer-forming process on a different substrate.

2. The method of claim 1, comprising monitoring the metric for a series of substrates undergoing the layer-forming process and feeding back results of the monitoring for controlling the layer-forming parameter.

3. The method of claim 2, wherein at each position the monitoring comprises measuring an asymmetry between two diffractive orders associated with a marker at the position and measuring overlay associated with the marker, wherein the metric is a ratio between the measured asymmetry and the measured overlay associated with the marker.

4. The method of any preceding claim, wherein the layer-forming parameter is a down force pressure pattern for pressure rings of a CMP tool.

5. The method of any of claims 1 to 3, wherein the layer-forming parameter is a layer deposition pattern for a layer deposition tool.

6. A device manufacturing method comprising:
forming a layer on a substrate by a layer-forming process according to a layer-forming parameter;
controlling the layer-forming parameter according to the method of any preceding claim; and
repeating the layer-forming process on a different substrate according to the controlled layer-forming parameter.

7. A computer program product comprising machine-readable instructions for causing one or more processors to control a layer-forming parameter of a layer-forming process by:
measuring an asymmetry between two diffractive orders associated with a marker at a plurality of positions across a substrate, wherein the marker comprises a bottom grating and a top grating, wherein a distance between the bottom grating and the top grating corresponds to a thickness of a layer;
determining a value of a metric at the plurality of positions across the substrate, the metric being calculated from the measured asymmetry and an offset associated with the marker, wherein variation of the values across the substrate is indicative of variation of layer thickness across the substrate; and
controlling the layer-forming parameter based on the values so as to reduce variation of layer thickness in a subsequent layer-forming process on a different substrate.
